Europäisches Patentamt

European Patent Office

Office européen des brevets

(19)

(11) Publication number: 0 315 257
A1

# EUROPEAN PATENT APPLICATION

(21) Application number: 88202402.9

(22) Date of filing: 28.10.88

(51) Int. Cl.⁴: G06F 11/20

(30) Priority: 02.11.87 NL 8702606

(43) Date of publication of application:
10.05.89 Bulletin 89/19

(84) Designated Contracting States:
DE ES FR GB IT

(71) Applicant: N.V. Philips' Gloeilampenfabrieken
Groenewoudseweg 1
NL-5621 BA Eindhoven(NL)

(72) Inventor: Steenhof, Frits Anthonie
c/o INT. OCTROOIBUREAU B.V. Prof.
Holstlaan 6
NL-5656 AA Eindhoven(NL)
Inventor: Lismore, Kieran
c/o INT. OCTROOIBUREAU B.V. Prof.
Holstlaan 6
NL-5656 AA Eindhoven(NL)

(74) Representative: Strijland, Wilfred et al
INTERNATIONAAL OCTROOIBUREAU B.V.
Prof. Holstlaan 6
NL-5656 AA Eindhoven(NL)

(54) Series-parallel-series memory comprising redundant storage columns, and picture memory comprising such series-parallel-series memories.

(57) A series-parallel-series memory comprises one or more redundant storage columns which are skipped when a row of information is input/output. The identification of a faulty column to be replaced by a redundant column is stored, in the form of a bit combination contained in respective bit cells, in a read-only memory. The cells have a double readability, i.e. independently for input and output. Each memory cell comprises one fuse whose information can be addressed independently via two word lines in order to output this information on each time a separate bit line.

FIG.1

# Series-parallel-series memory comprising redundant storage columns, and picture memory comprising such series-parallel-series memories.

## BACKGROUND OF THE INVENTION

The invention relates to a series-parallel-series memory, comprising at least one redundant storage column and a selection mechanism for selecting an assigned, operational column for at least one known faulty storage column during serial input as well as serial output. A memory of this kind is known from United States Patent Specification 4,563,752 (PHN 10.368) assigned to the present Applicant. In the known memory the redundant columns are at least one storage position shorter than the other storage columns. The information of a redundant column is formed at the end of a row of information and becomes available one row sooner when a read operation is performed. Consequently, correction can be readily organized, because substitute information becomes available at a very early stage when a row of information is read. Such a memory can be used for multi-valent or bivalent information; however, for the sake of simplicity, only the latter form will be considered hereinafter. The selection mechanism can be realized in various ways. In the embodiment to be described hereinafter, a faulty column is skipped and all bits arriving later are shifted one position further. After a second faulty column, all bits arriving later are shifted two positions further, and so on. Alternatively, the bit intended for a faulty column can be stored in one of the additional columns. In that case a storage element is required for the bit intended for the faulty column, which storage element is read again upon completion of the input of a row of bits. In both cases a memorization mechanism is required for memorizing the position of the faulty columns, for example as a rank number. Input in and output from such a memory can usually take place independently on a bit basis. The input and output are not independent on a row basis, because the parallel storage columns are always activated in synchronism by means of a single clock pulse. For input and output the information of the faulty column (columns) must then be available in an independent manner.

## SUMMARY OF THE INVENTION

The invention inter alia aims to construct a series-parallel-series memory of the kind set forth so that the information of faulty column numbers is independently available for input and output, that is to say by way of a memory of limited size, in that use is made of a read-only memory which can be programmed by a single fuse per cell and which has a dual readability per cell, the number of fuses thus reduced also resulting in a reduction of the programming time.

It is a first feature of the invention that for the storage of an identification, consisting of several bits, of any faulty column there is provided a read-only memory which can be addressed by the selection mechanism and which can be programmed by means of fuses, which read-only memory comprises for each bit cell a single fuse and its information can be addressed via two independent word lines, that is to say an input interrogation line and an output interrogation line, in order to activate a bit line associated with the respective word line by means of the information stored in the cell in order to activate said selection mechanism. A fuse element is to be understood to mean an element whose forward resistance can be modified once during the manufacturing process or at a later stage. It is known to impart a high resistance to such a fuse by means of laser irradiation or a temporarily increased current. It is also known to make the resistance selectively low by burning through an insulating layer by means of one of said techniques, resulting in a substantially reduced resistance. The laser irradiation is usually sequentially performed for the respective fuses; burning through with an increased current can often take place also at least partly in parallel.

## FURTHER ASPECTS OF THE INVENTION

It is a further feature of a preferred embodiment that, in the presence of several redundant columns, said read-only memory comprises an input faulty-column cuunter and an output faulty-column counter for addressing successive word locations of the read-only memory and for applying multi-bit information read to an input address comparator and an output address comparator, respectively, whereto there are also applied a current input address and a current output address, respectively, in order to activate said selection mechanism when correspondence is found and to adjust the associated counter of the input address counter and the output address counter to a new address. This results in a systematic and correctly operating organization which can be readily adapted to the size of the memory and the anticipated number of faulty columns.

The series-parallel-series memory can be distributed over several matrices. The described set-up can then still be used to good advantage. Each bit line is preferably connected to a latch element so that low current consumption is realized.

The invention also relates to a picture memory comprising at least two parallel-connected series-parallel-series memories of the kind set forth. Inexpensive memories are attractive notably for such applications. On the other hand, such a series-parallel-series memory can also be used for the storage of speech. Because the bit frequency is much lower in that case, sometimes only one series-parallel-series memory then already suffices (with parallel-series conversion at the input and series-parallel conversion at the output). Storage is in any case organized on the basis of samples.

Further features of the invention are recited in the dependent Claims.

BRIEF DESCRIPTION OF THE FIGURES

The invention will be described in detail hereinafter with reference to some Figures.

Figure 1 shows a block diagram of a series-parallel series memory;

Figure 2 shows the circuit of a first selection mechanism;

Figure 3 shows a circuit of a second selection mechanism;

Figure 4 shows a read-only memory for use in a series-parallel-series memory in accordance with the invention;

Figure 5 shows a memory cell thereof;

Figure 6 shows a time diagram relating to control signals.

SYSTEM DESCRIPTION

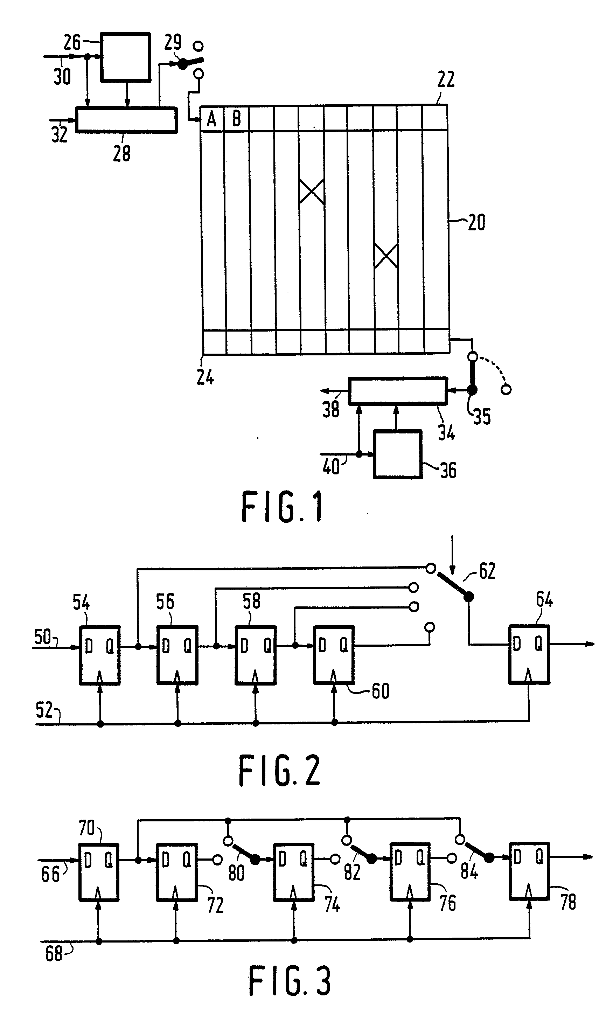

Figure 1 shows a block diagram of a series-parallel-series memory in which the invention can be used. There is provided an actual memory with an input shift register 22, a number of storage columns or strings 20, and an output shift register 24. Each of the shift registers of the present embodiment comprises 10 stages and there are ten columns accommodating, for example, eight bits each. These storage capacities will usually be much higher in practice. The input information is received on terminal 32. A synchronizing clock pulse train appears on an input 30. Element 28 is a temporary storage mechanism in which the information is positioned so that for each faulty column a redundant column is activated. The substitution is controlled by an element 26 in which it is known which columns must be replaced by which columns. The combination of the elements 26 and 28 thus constitutes the substitution mechanism. Assume that the columns A and B are redundant columns and that two columns cannot be used (as indicated by a cross). One possible strategy consists in that the bits actually intended for these two columns are retained in the element 28 (under selective control by the element 26) and are joined to the rear of the row so that they arrive in the columns A and B.

After the input of the row of bits, the latter bits are taken over in the respective columns A, B under the influence of a control circuit (not shown). After a number of these rows have been successively received, the first row arriving enters the series output shift register 24. Therein, either the bits which correspond to the two faulty columns are missing or their information is unreliable. According to the cited state of the art, the substitute bits are output one line sooner, so that they have already arrived in the temporary storage mechanism 34 in which they are temporarily retained. Upon serial shifting out of the register 24, they are substituted at the location of the faulty columns under the control of the element 36. The elements 34, 36 thus together constitute the substitution mechanism. The output information then appears on the line 38, the output clock pulses being received on the line 40, for example from a user device such as a display device.

It will be apparent that the elements 26, 36 contain the same information, i.e. the information indicating the faulty columns. As is shown, the series-parallel-series memory consists of a single storage matrix. In given cases a larger number of storage matrices will be chosen. On the one hand, all matrices may be separately provided with the elements 26, 28, 34, 36. On the other hand, they may also share the latter elements; for this purpose a demultiplexer switch 29 is provided at the input side in Figure 1 and a multiplexer switch 35 at the output side. In that case there are, for example 2, 4 or 8 matrices, each of which comprises the elements 20, 22, 24. The switches 29, 35 can be bit-wise advanced, but also on the basis of a group of, for example 8 bits, or even on the basis of the full length of the register pair 22/24 (in practice, the latter will be much larger than 8 bits). Therefore, the redundant columns may form part of a single matrix in the latter case.

DETAILED DESCRIPTION OF TWO SELECTION MECHANISMS

Figure 2 shows a circuit for activating a redundant column for a faulty column during an input operation. In this case the faulty column is skipped and all further data bits are shifted one position further with respect to the faulty column. The circuit comprises five flipflops (data flipflops). These flipflops receive clockpulses via line 52. The information appears on line 50. Switch 62 initially occupies the upper position. As a result, the delay amounts to 2 clock pulse periods. When a column is to be skipped, the switch 62 is set to the next position, after which the delay amounts to three clock pulse periods. Thus, in total three columns having arbitrary rank numbers can be skipped. Other numbers are also feasible. At the beginning of a next row the switch 62 is set to the upper position again. At the information level this means that the data bit intended for a faulty column is each time repeated once; in the case of two neighbouring faulty columns, this bit is repeated twice, etc.

Figure 3 shows a circuit for substituting correct information for the information originating from a faulty column during a read operation. The circuit comprises five data flipflops 70, 72, 74, 76, 78 and three switches 80, 82, 84. At the beginning of the read operation all switches occupy the lower position and the delay time amounts to five periods of the clock pulses on line 68; the data bits appear on input 66. When a bit originating from a faulty column is to be skipped, the switch 80 is set to the upper position as shown, so that the delay is reduced by one clock pulse period. When a second column is to be skipped, the switch 82 is set to the upper position and the switch 84 is set to the upper position if a third column is to be skipped, so that the delay amounts to two clock pulse periods only. It is possible to skip a plurality of adjacently situated columns. Figures 2, 3 thus offer a possible implementation for the elements 28 and 34, respectively, in Figure 1.

## CONTROL OF THE SELECTION

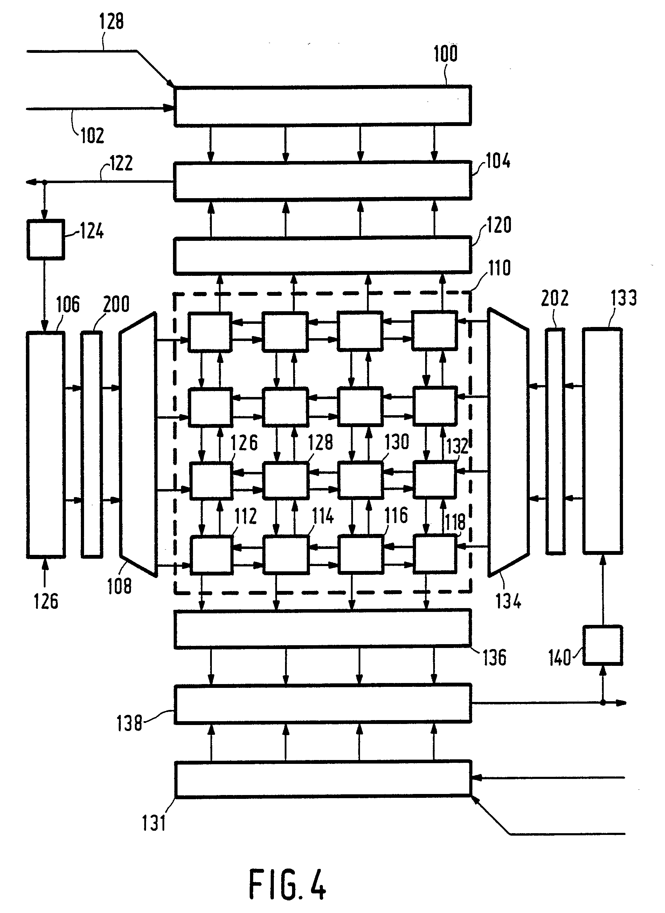

Figure 4 shows a read-only memory for use in a series-parallel-series memory of the described kind, together with the associated control circuitry. First the procedure for the input of a row of bits will be described. The circuit shown in Figure 4 comprises an input column counter 100 which is advanced one position for each clock pulse applied to the input shift register (terminal 102). The contents of this counter are applied to a comparator 104. There is also provided an input faulty column counter 106 which occupies or is set to the zero position when the input of a row of bits commences. The position of this counter is decoded in a decoder 108 which then addresses one row of a memory matrix 10, for example the lower row. The contents of this row of memory cells (112, 114, 116, 118) are then applied to output circuits 120 which have a latch function in conjunction with the respective memory cells. The information of these circuits 120 indicates a faulty column to be skipped during input, in that the switch 62 of Figure 2 is advanced one position. This takes place when the column counter 100 reaches this position and hence the comparator 104 detects correspondence and supplies a bit signal on output 122. The control of the switch 62 by the latter signal is not shown in detail for the sake of simplicity. The signal on the output 122 is also applied to the input faulty column counter 106, via an element 124 which implements, for example, a short delay so that the input faulty column counter 106 counts one position further and subsequently addresses the next column of the memory matrix 110, for example the column which comprises the cells 128, 130, 132. This procedure is subsequently repeated. Before the start of the input of a new row of bits, the counters 100, 106 must be reset to the zero position; inputs 126, 128 are provided for this purpose.

For output there is provided a circuit which is similar to that used for input; it comprises a column counter 131, a faulty column counter 133, a decoder 134, a latch circuit 136, a comparator 138, and a delay element 140. The cells of the matrix 110 comprise a facility for double and independent addressability, so that the cells themselves need not be provided twice. For the sake of simplicity, any synchronization of the elements 108, 104, 134, 138 has been omitted in the above description. The function of the inhibit elements 200, 202 will be described in detail hereinafter. It will be apparent that the size of the matrix 110 will usually be much larger in practice.

## DESCRIPTION OF A MEMORY CELL

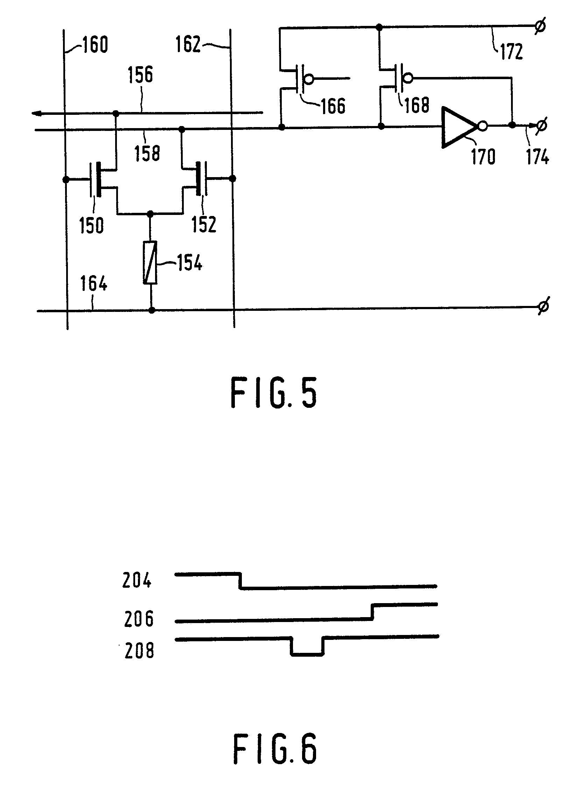

Figures 5 shows a preferred embodiment of a memory cell to be used in Figure 1, together with an associated latch element. The memory cell comprises first of all a fuse element 154. On the integrated circuit this element is realized as a strip of polysilicon which can be interrupted, for example by means of a laser. In a given case it was found that the interruption of such a fuse element required 10 ms. In a given integrated circuit 12 columns could thus be deactivated. Per column a 14-bit code was present, so that there were 168 columns in total. In principle coding could then require 1.7 s. This period was found to be shorter in practice, because part of the code was not binary, but rather a 1-out-of-4 code. This was because the series-parallel-series memory was subdivided into four separate sub-memories and the external data connections had a width of four bits.

The read-only memory was common to the four series-parallel-series sub-memories. The redundant columns, and also the mechanisms shown in the Figures 2, 3, were separately provided for each of the four sub-memories. The first four bits of the 14-bit code then indicate only which of the four matrices comprises a faulty column, so that a column need be skipped only for that matrix. Within the respective matrices, however, the same addresses apply. For a number of upto 1024 addresses (columns) ten address bits suffice. A further reason why in practice fewer fuses need be interrupted on average is that for the binary coded part on average only half the number of fuses actually had to be interrupted, and finally that the redundancy capacity was usually only partly used, for example only 1/4. In that case only $3 \times (1 + 1/2 \times 10) = 18$ fuses need actually be interrupted on average, requiring a period of 180 ms. The saving in time with respect to an embodiment comprising twice as many memory cells in the read-only memory, which cells, however, could be read only singularly, thus also amounts to 180 ms on average. If the resistance of the elements deemed to be fused is influenced by a parallel-wise executed process step, the advantage of the saving in time will be lost and only the advantage of the saving in space in accordance with the invention will remain. The state of the element 154 determines the information content of the cell. In the conductive state the resistance amounts to, for example 250 ohms; in the interrupted state it amounts to, for example at least 100 kohms, and in theory even much more. For the reading of the state of the information there are provided first of all a word line 162 and an nMOS transistor 152 which is driven thereby. This transistor is turned on when the gate carries a high potential and is turned off when the gate carries zero potential. Line 164 carries a low potential VSS. When the transistor 152 is turned off, the bit line 158 remains at a high potential. When the fuse 154 has a low resistance (i.e. when it is not interrupted) and the transistor 152 is turned on, the potential on the bit line 158 becomes low, because the bleeder transistor 168 is weaker than the element 152 (the voltage drop across the element 168 is then large with respect to that across the element 152). When the fuse 154 has a high resistance, the bit line 158 remains at a high potential, regardless of the signal on the gate of the transistor 152. The memory cell is also connected to a second word line 160, via an nMOS transistor 150, and to a bit line 156. The read mechanism thus formed can operate fully independently of the previous read mechanism, because the resistance of the fuse 154 can be sufficiently changed. It would in principle be possible to provide even a third read mechanism.

The information of the memory cell is applied to an external circuit. The latter circuit comprises notably two pMOS transistors 166, 168 and an inverter 170. Terminal 172 carries a high supply voltage VDD. The pMOS transistors are turned on when their gate carries a low potential and are turned off when their gate carries a high potential. The gate of the transistor 166 receives a precharge pulse at the beginning of a cycle during which the latch element must be loaded again. This precharge pulse can thus be activated under the control of an output signal of one of the elements 124, 140 in Figure 4. As a result, the line 158 briefly carries a high potential so that a DC connection to ground could arise via the transistor 152 when the fuse 154 has a low resistance. In order to prevent this, the inhibit elements 200, 202, are provided in Figure 4. In this respect reference is also made to Figure 6 which shows a time diagram for a few control signals. Curve 204 represents a first word line selection signal as it could be generated by the decoder 108. For example, the lower row of memory cells in the matrix 110 of Figure 4 is addressed thereby. When the position of the counter 126 is incremented by one, the decoder 108 would generate a second word line selection signal, for example for the next-higher row of memory cells. A step is taken to ensure that a given interval exists between the presence of the two word line selection signals, no word line being selected during said interval. This is shown in Figure 6 in which an interval exists between the negative-going edge of the curve 204 and the positive-going edge of the second word line selection signal on the curve 206. The precharge signal for the transistor 166 as represented in the curve 208 occurs during this interval, so that the transistor 152 is then turned off in any case; this also applies to the other transistors 150 etc. An interval can be realized in various ways:

- inhibit element 200 is connected between the decoder 108 and the respective word selection lines and is driven by a signal from the element 124 (exhibiting the appropriate time relationship) and a signal which activates the bias pulse during a clock cycle. When these signals are simultaneously present, all outputs of the decoder 108 become low;

- in a preferred embodiment there are provided 12 word lines and the element 126 is a four-bit counter. As is shown, the inhibit element 200 is then connected between the counter 126 and the decoder 108. Only 12 of the 16 counter positions are then used for driving the word lines. The inhibit element is then controlled in the same way as for the first possibility described and emulates a non-used counter position, so that none of the word lines is then effectively driven. The formation of the control signal for the inhibit element 200 has been omitted for the sake of simplicity. An inhibit element 202 is similarly arranged between the elements 133 and 141. When a part of the rows is formed by a 1-out-of-n code which is activated by the position of the multiplex/demultiplex switches 29/35 of Figure 1, an inhibit effect can be realized for the relevant word lines in an analogous manner.

If, after the preloading by means of the transistor 166, the transistor 152 is turned on when the memory cell is addressed by a high signal on the line 162, the line 158 becomes low and the output of the inverter 170 becomes high, so that the transistor 168 switches over from the turned-on state to the turned-off state. When the transistor 152 is connected in series with a high-ohmic fuse 154, the line 158 remains high and the output of the inverter 170 becomes low, so that the transistor 168 remains turned on in order to keep the line 158 at a high potential; the output 174 is applied to the comparator. With the exception of the brief interval shown in Figure 6, the word line selection signals remain continuously active in the present embodiment. It is also possible to provide, for example an external register so that the activation need only be brief.

In a preferred embodiment the number of columns amounted to 720, distributed over 8 sub-matrices. There were 4 of these sub-memories for a signal having a width of 4 bits. The number of cells per column amounted to 320, so that the total number of cells amounted to approximately 922,000. Due to the shift technique used in the columns (with so-called ripple transfer signals), the information storage capacity was actually approximately 10% smaller. Three of such memories connected in parallel can accommodate 12 bits per pixel for a television picture, for example 8 bits for brightness and 4 bits for colour. The colour information is then combined for a number of successive pixels by filtering.

## Claims

1. A series-parallel-series memory, comprising at least one redundant storage column and a selection mechanism for selecting an assigned, operational column for at least one known faulty storage column during serial input as well as serial output, characterized in that for the storage of an identification, consisting of several bits, of any faulty column there is provided a read-only memory which can be addressed by the selection mechanism and which can be programmed by means of fuses, which read-only memory comprises for each bit cell a single fuse and its information can be addressed via two independent word lines, that is to say an input interrogation line and an output interrogation line, in order to activate a bit line associated with the respective word line by means of the information stored in the cell in order to activate said selection mechanism.

2. A series-parallel-series memory as claimed in Claim 1, characterized in that, in the presence of several redundant columns, said read-only memory comprises an input faulty column counter and an output faulty column counter for addressing successive word locations of the read-only memory and for applying multi-bit information read to an input address comparator and an output address comparator, respectively, whereto there are also applied a current input address and a current output address, respectively, in order to activate said selection mechanism when correspondence is found and to adjust the associated counter of the input faulty column counter and the output faulty column counter to a new address.

3. A series-parallel-series memory as claimed in Claim 1 or 2, characterized in that the activation of the selection mechanism consists in the formation of a skip control signal for a series input register and a series output register, respectively, in order to skip a faulty column in response thereto.

4. A series-parallel-series memory as claimed in Claim 2 or 3, characterized in that it is subdivided into a plurality of series-parallel-series matrices which are arranged in a demultiplex/multiplex organization between a general data input and a general data output, each of said matrices comprising at least one redundant column.

5. A series-parallel-series memory as claimed in Claim 2, 3 or 4, characterized in that external data connections have a width of several bits in order to store the relevant bits in a corresponding number of sub-memories, said read-only memory being common to the sub-memories in that a part of said several bits indicates a respective sub-memory in a 1-out-of-n code.

6. A series-parallel-series memory as claimed in any one of the Claims 1 to 5, characterized in that said bit cell comprises two transistor elements which are connected, by way of a respective first electrode, in series with said fuse and mutually in parallel, the respective control electrodes thereof being connected to a respective word line, their third electrode being connected to a respective bit line.

7. A series-parallel-series memory as claimed in Claim 6, characterized in that at an output side of each bit line there is formed a fed back latch element in that at that area the relevant bit line is coupled, via an inverter, to a control electrode of a bleeder transistor which is of opposite conductivity type with respect to the previously mentioned transistor elements and which has a blocking resistance which is high with respect to the series resistance of the transistor element and the fuse in the conductive state.

8. A series-parallel-series memory as claimed in any one of the Claims 1 to 7, in which the read-only memory comprises several word lines which are selectively activated in order to compare information stored therein with an input/output address counter position for identification of a faulty storage column, characterized in that there is provided an inhibit mechanism (200, 202) for blocking any activation of any word line during an interval between successive activations of two different word lines.

9. A picture memory comprising at least two parallel-connected series-parallel-series memories as claimed in any one of the Claims 1 to 8 and having a capacity which suffices for a picture of the size of a television picture.

10. A series-parallel-series memory as claimed in any one of the Claims 1 to 8, in which the storage is organized on the basis of multi-bit speech samples, there being provided means for receiving these samples in parallel on an input and for outputting these samples in parallel on an output.

FIG.1

FIG.2

FIG.3

FIG. 4

FIG.5

FIG.6

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | GB-A-2 121 996 (PHILIPS CORP.) <br> * Page 2, line 92 - page 3, line 47; page 5, line 41 - page 7, line 53 * | 1 | G 06 F 11/20 |
| A | ELECTRONICS AND COMMUNICATIONS IN JAPAN, vol. 66-C, no. 5, May 1983, pages 97-106, Scripta Publishing Co., Silver Spring, Maryland, US; T. TOYOOKA et al.: "Design and operation of a high-speed bubble memory board" <br> * Page 101, left-hand column, line 16 - page 103, left-hand column, line 10 * | 1 | |
| A | US-A-4 580 245 (ZIEGLER et al.) <br> * Column 2, line 6 - column 3, line 39 * | 1 | |

TECHNICAL FIELDS
SEARCHED (Int. Cl.4)

G 06 F 11/20
G 11 C 8/00
G 11 C 19/00
H 03 M 9/00

The present search report has been drawn up for all claims

| Place of search | Date of completion of the search | Examiner |
|---|---|---|
| THE HAGUE | 29-11-1988 | HERREMAN,G.L.O. |